# EUROPEAN PATENT APPLICATION

(11) **EP 4 482 039 A1**
(43) Date of publication of application: **25.12.2024**
(21) Application number: 23219590.9
(22) Date of filing: 22.12.2023
(51) Int. Cl.: H03M 13/13, H03M 13/00, H04W 52/02, G06F 1/26, H04L 12/12

(54) **APPARATUS AND METHOD FOR SUCCESSIVE CANCELLATION LIST DECODING OF POLAR CODE USING POWER GATING**

(30) Priority: 20.06.2023 KR 20230078970
(71) Applicant: Ajou University Industry-Academic Cooperation Foundation, Suwon-si, Gyeonggi-do 16499 (KR)
(72) Inventor: SUNWOO, Myung Hoon, 06676 Seoul (KR); HISHE, Hintsa Fisseha, 18450 Hwaseong-si, Gyeonggi-do (KR); LEE, U Seok, 16519 Suwon-si Gyeonggi-do (KR)
(74) Representative: Isarpatent

(57) **Abstract**

An apparatus and method for successive cancellation list decoding of polar codes using power gating are provided. The apparatus for successive cancellation list decoding of polar codes using power gating according to one embodiment includes a plurality of successive cancellation list decoders configured to receive a polar encoded codeword and decode the codeword using a successive cancellation list technique and a power gating circuit connected to a preset number of successive cancellation list decoders among the plurality of successive cancellation list decoders to control current supply.

## Description

### BACKGROUND

### 1. Field

Embodiments of the present disclosure relate to a successive cancellation list decoding technique of polar codes using power gating.

### 2. Description of Related Art

A polar code is the first error correcting code capable of achieving channel capacity in discrete memoryless channels. The polar code uses a successive cancellation (SC) algorithm as a basic decoding method, but it has a disadvantage. The polar code shows low error correction performance compared to the low-density parity-check (LDPC) code and the turbo code.

In order to improve this disadvantage, several decoding methods for increasing error correction performance based on the successive cancellation algorithm have been presented. One of the presented decoding methods is a successive cancellation list (SC list (SCL)) decoding method. The SCL decoding method is basically the same as the SC decoding method, but the difference is that there are as many paths as powers of 2 (L = 2^{l}, 1 = 1, 2, 3, ...). The number of the paths is a list size of SCL decoding. In the SCL decoding method, each of the paths performs individual SC decoding, and the bits decoded in each path are stored to obtain a final codeword decoded in that path. In the SCL decoding method, each path is copied into two paths each time one information bit is decoded. That is, as decoding progresses, L paths increase to 2L paths, and through a path selection process, the L paths with the highest reliability are selected again. When all bits are decoded, a cyclic redundancy check (CRC) is performed on each path result, and the codeword of the path that passes the CRC is output as the final decoding result. When this SCL decoding method is used, the low error correction performance of the SC decoding method may be improved.

That is, the SCL decoding method may decode polar codes with improved error correction performance. However, the SCL decoding method has a disadvantage of requiring approximately L times as much computation (the size of the list) as the existing SC decoding method.

Examples of the related art include Korean Patent Registration No. 10-1951663 (Date: February 19, 2019).

### SUMMARY

Embodiments of the present disclosure are intended to provide an apparatus and method for successive cancellation list decoding of polar codes using power gating.

In one general aspect, there is provided an apparatus for successive cancellation list decoding of polar codes using power gating includes a plurality of successive cancellation list decoders configured to receive a polar encoded codeword and decode the codeword using a successive cancellation list technique and a power gating circuit connected to a preset number of successive cancellation list decoders among the plurality of successive cancellation list decoders to control current supply.

The power gating circuit may include a signal generator configured to generate a power signal according to a preset condition and a current controller configured to control current supply to the preset number of successive cancellation list decoders by increasing or decreasing a gate voltage of a sleep transistor according to the generated power signal.

The signal generator may be configured to generate a first power signal to block current supply to the preset number of successive cancellation list decoders in a decoding process when the plurality of successive cancellation list decoders receive the codeword.

The signal generator may be configured to generate a second power signal to block current supply to the preset number of successive cancellation list decoders in a preset section during a decoding process when the plurality of successive cancellation list decoders receive the codeword.

The signal generator may be configured to extract a Rate-1 node from the codeword when the plurality of successive cancellation list decoders receive the codeword and generate the second power signal to block current supply to the preset number of successive cancellation list decoders in a section corresponding to the Rate-1 node in the decoding process.

### BRIEF DESCRIPTION OF THE DRAWINGS

FIG. 1 is a diagram illustrating an apparatus for successive cancellation list encoding and decoding of polar codes according to one embodiment of the present disclosure.
FIG. 2 is a diagram illustrating an apparatus for successive cancellation list decoding of polar codes using power gating according to one embodiment of the present disclosure.
FIG. 3 is a diagram illustrating a method of operating the apparatus for successive cancellation list decoding of polar codes using power gating according to one embodiment of the present disclosure.
FIG. 4 is a diagram illustrating a method of operating the apparatus for successive cancellation list decoding of polar codes using power gating according to another embodiment of the present disclosure.
FIG. 5 is a graph comparing error correction performances according to apparatuses for decoding of polar codes.
FIG. 6 is a diagram illustrating a reduction rate of the amount of calculation of the apparatuses for successive cancellation list decoding of polar codes using power gating according to disclosed embodiments.
FIG. 7 is a block diagram for exemplarily illustrating a computing environment including a computing device according to one embodiment.

### DETAILED DESCRIPTION

Hereinafter, specific embodiments of the present disclosure will be described with reference to the accompanying drawings. The following detailed description is provided to assist in a comprehensive understanding of the methods, devices and/or systems described herein. However, the detailed description is only for illustrative purposes and the present disclosure is not limited thereto.

In describing the embodiments of the present disclosure, when it is determined that detailed descriptions of known technology related to the present disclosure may unnecessarily obscure the gist of the present disclosure, the detailed descriptions thereof will be omitted. The terms used below are defined in consideration of functions in the present disclosure, but may be changed depending on the customary practice, the intention of a user or operator, or the like. Thus, the definitions should be determined based on the overall content of the present specification. The terms used herein are only for describing the embodiments of the present disclosure, and should not be construed as limitative. Unless expressly used otherwise, a singular form includes a plural form. In the present description, the terms "including", "comprising", "having", and the like are used to indicate certain characteristics, numbers, steps, operations, elements, and a portion or combination thereof, but should not be interpreted to preclude one or more other characteristics, numbers, steps, operations, elements, and a portion or combination thereof.

Meanwhile, the embodiments of the present disclosure may include a program for performing the methods described herein on a computer, and a computer-readable recording medium including the program. The computer-readable recording medium may include program instructions, a local data file, a local data structure, or the like alone or in combination. The media may be specially designed and configured for the present disclosure, or may be commonly used in the field of computer software. Examples of computer-readable recording media include magnetic media such as hard disks, floppy disks and magnetic tapes, optical recording media such as a CD-ROM and a DVD, and hardware devices specially configured to store and execute program instructions such as a ROM, a RAM, and a flash memory. Examples of the program may include not only machine language codes such as those produced by a compiler, but also high-level language codes that can be executed by a computer using an interpreter or the like.

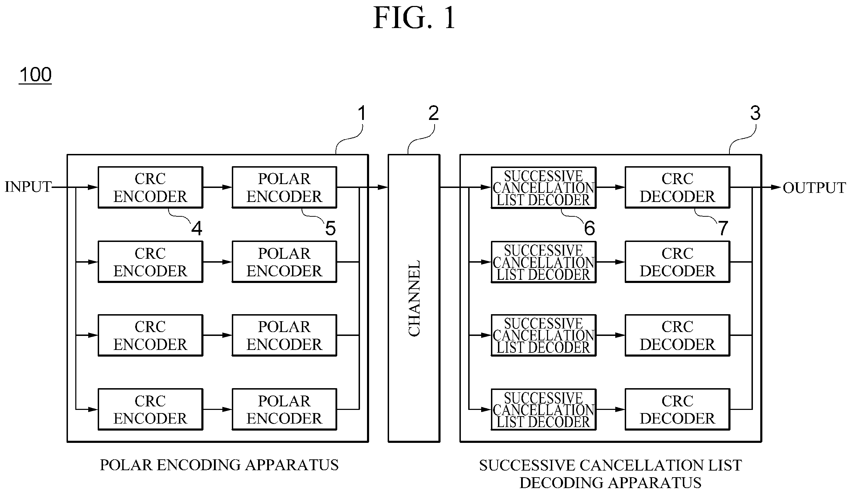

FIG. 1 is a diagram illustrating an apparatus for successive cancellation list encoding and decoding of polar codes according to one embodiment of the present disclosure.

Referring to FIG. 1, in the present disclosure, a polar encoding apparatus 1 and a successive cancellation list decoding apparatus 3 used in a communication system will be described as one example. The polar encoding apparatus 1 may encode data (information bits) to be transmitted through polar encoders 5 and transmit the encoded data (codewords) through a channel 2 to the successive cancellation list decoding apparatus 3. Here, the polar code is a code that achieves channel capacity by using the channel polarization phenomenon that occurs when multiple channels are combined and then properly separated. In addition, the successive cancellation list decoding apparatus 3 may decode the codeword received from the polar encoding apparatus 1 through the channel 2 with successive cancellation list decoders 6 based on a successive cancellation list (SCL) decoding technique, and estimate and output data encoded by the polar encoding apparatus 1. In this case, a CRC code is generated by operating the CRC encoders 4 of the polar encoding apparatus 1, and a check as to whether an error has occurred in the data is performed by comparing a CRC code of a result value generated through the CRC decoders 7 of the successive cancellation list decoding apparatus 3 with the CRC code generated by the CRC encoders 4. When there are no errors in the check for error occurrence, the data is output.

Such a successive cancellation list decoding apparatus 3 includes L (the size of the list) successive cancellation list decoders 6 that operate simultaneously and in parallel. In this case, the successive cancellation list decoding apparatus 3, which includes the L successive cancellation list decoders 6, requires the area and the amount of calculation approximately L times larger than the existing successive cancellation decoding apparatus. In particular, the amount of calculation is directly related to power consumption, and the successive cancellation list decoding apparatus 3 consumes approximately L times more power than the successive cancellation decoding apparatus.

In the present disclosure, power supply of some of the L successive cancellation list decoders 200 may be controlled using power gating, thereby providing a method capable of reducing the amount of calculation and the amount of power consumption of an apparatus 100 for successive cancellation list decoding of polar codes.

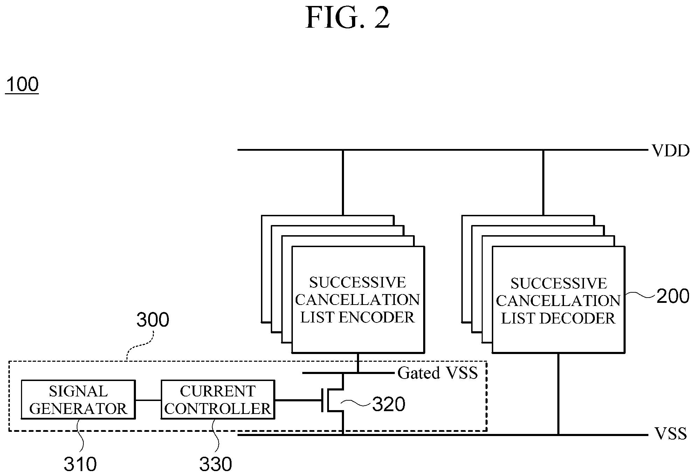

FIG. 2 is a diagram illustrating an apparatus for successive cancellation list decoding of polar codes using power gating according to one embodiment of the present disclosure.

Referring to FIG. 2, an apparatus 100 for successive cancellation list decoding of polar codes using power gating according to one embodiment may include successive cancellation list decoders 200 and a power gating circuit 300.

In the following embodiment, each component may have different functions and capabilities in addition to those described below, and additional components may be included in addition to those not described below.

In addition, in the following embodiment, the successive cancellation list decoders 200 and the power gating circuit 300 may be implemented by using one or more physically separated devices or be implemented by one or more processors or a combination of one or more processors and software, and may not be clearly distinguished in specific operations, unlike the illustrated example.

The successive cancellation list decoders 200 may decode a received codeword using a successive cancellation list method.

Meanwhile, the successive cancellation list method used in the present disclosure is a known technology, and thus detailed description thereof will be omitted; however, to briefly describe, the successive cancellation list decoding method is a decoding method proposed by Tal and Vardy in 2011 for improving the existing polar code successive cancellation (SC) decoding performance.

The power gating circuit 300 may control current supply to the successive cancellation list decoders 200. In addition, the power gating circuit 300 may include a signal generator 310, a sleep transistor 320, and a current controller 330. The power gating circuit 300 may control the current supply to the successive cancellation list decoders 200 by the current controller 330 increasing or decreasing a gate voltage of the sleep transistor 320 according to a power signal generated by the signal generator 310. For example, since the sleep transistor 320 is in a linear region in an active mode, a gated VSS has a value close to VSS. Meanwhile, since the sleep transistor 320 is turned off in a sleep mode, the gated VSS has a value close to VDD. In this case, the power gating circuit 300 may be connected to a preset number of successive cancellation list decoders 200. For example, the power gating circuit 320 may be connected to four successive cancellation list decoders 200 among the eight successive cancellation list decoders 200.

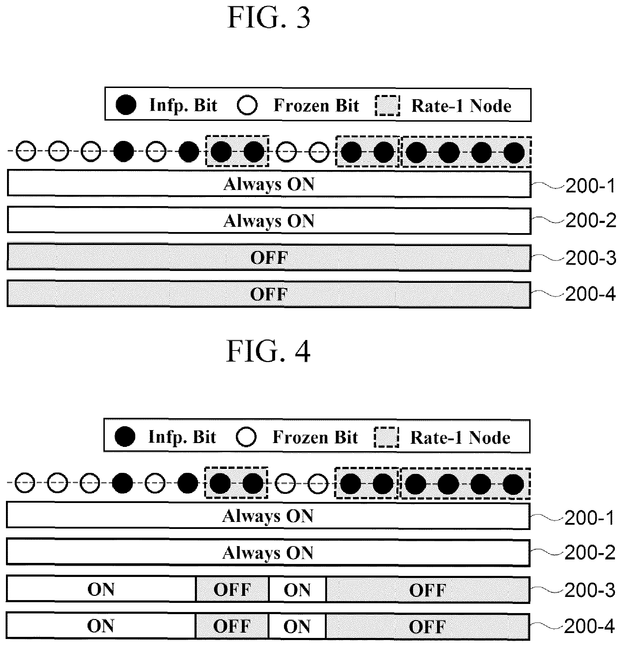

The signal generator 310 may generate a power signal according to a preset condition. A detailed description thereof will be provided with reference to FIGS. 3 and 4 below.

FIG. 3 is a diagram illustrating a method of operating the apparatus for successive cancellation list decoding of polar codes using power gating according to one embodiment of the present disclosure.

Referring to FIG. 3, when receiving a codeword with a total code length of 8 bits, the apparatus 100 for successive cancellation list decoding of polar codes using power gating according to one embodiment may block current supply to a preset number of decoders in a decoding process. Here, the codeword may be composed of information bits and frozen bits. In this case, the signal generator 310 may generate a power signal to block current supply to the preset number of successive cancellation list decoders 200 when the successive cancellation list decoders 200 receive the codeword. For example, by blocking power supply to M (e.g., two) successive cancellation list decoders 200-3 and 200-4 during decoding among L (e.g., four) successive cancellation list decoders 200-1, 200-2, 200-3, and 200-4, the amount of calculation and power consumption may be reduced in proportion to M/L. Here, L may refer to the total number of the successive cancellation list decoders 200, and M may refer to the number of successive cancellation list decoders 200 to which the power gating circuit is applied.

That is, the apparatus 100 for successive cancellation list decoding of polar codes using power gating according to one embodiment may select an error correction performance priority mode or a power efficiency priority mode by applying the power gating circuit to a certain number of successive cancellation list decoders 200.

FIG. 4 is a diagram illustrating a method of operating the apparatus for successive cancellation list decoding of polar codes using power gating according to another embodiment of the present disclosure.

Referring to FIG. 4, when receiving a codeword with a total code length of 8 bits, the apparatus 100 for successive cancellation list decoding of polar codes using power gating according to one embodiment may block current supply to a preset number of successive cancellation list decoders 200 in a preset section while decoding is in progress. Here, the codeword may be composed of information bits and frozen bits. In addition, the preset section may be a decoding section of a Rate-1 node. The Rate-1 node may refer to a node composed of information bits gathered together over a certain length. Here, a section including the seventh and eighth bits, a section including the eleventh and twelfth bits, and a section including the thirteenth to sixteenth bits may be Rate-1 nodes.

In this case, the signal generator 310 may extract the Rate-1 nodes from the codeword when the successive cancellation list decoders 200 receive the codeword and generate a power signal to block current supply to the preset number of successive cancellation list decoders 200 in sections corresponding to the Rate-1 nodes in a decoding process. For example, among L successive cancellation list decoders 200-1, 200-2, 200-3, and 200-4, current supply to M successive cancellation list decoders 200-3 and 200-4 may be blocked in the sections corresponding to the Rate-1 nodes while decoding is in progress.

That is, since decoding path splitting and pruning is performed on information bits in the SCL decoding process, by cutting off power to the preset number of successive cancellation list decoders 200 at the node (Rate-1) composed of information bits gathered together over a certain length, the amount of calculation and power consumption may be reduced.

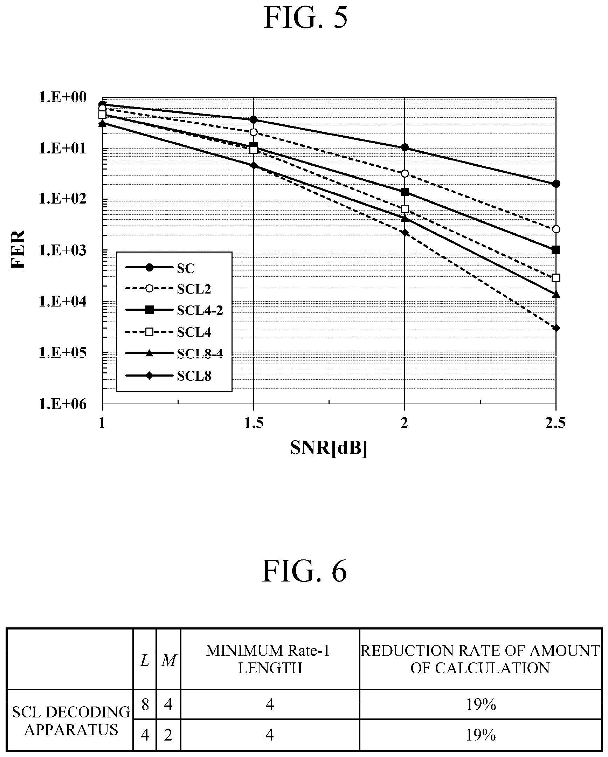

FIG. 5 is a graph comparing error correction performances according to apparatuses for decoding of polar codes, and FIG. 6 is a diagram illustrating a reduction rate of the amount of calculation of the apparatuses for successive cancellation list decoding of polar codes using power gating according to the disclosed embodiments.

Referring to FIGS. 5 and 6, when polar codes are decoded using the apparatus 100 for successive cancellation list decoding of polar codes using power gating according to one embodiment of the present disclosure, although error correction performance deteriorates compared to the same list size, the amount of calculation may be reduced compared to the same list size, which may reduce the amount of power consumption. For example, SCL 8-4 has a deterioration in error correction performance compared to SCL 8, but it can be seen that error correction performance is improved compared to SCL 4, and SCL 8-4 reduces the amount of calculation by 19% compared to SCL 8. Here, SCL 8-4 may mean that power gating is applied to four successive cancellation list decoders 200 among eight successive cancellation list decoders 200, and SCL 4-2 may mean that power gating is applied to two successive cancellation list decoders 200 among four successive cancellation list decoders 200.

That is, when only some of the successive cancellation list decoders 200 are used in the apparatus 100 for successive cancellation list decoding of polar codes, the error correction performance deteriorates compared with when all successive cancellation list decoders 200 are operated, but it can be seen that the effect of reducing the amount of calculation and thus reducing the amount of power consumption is produced.

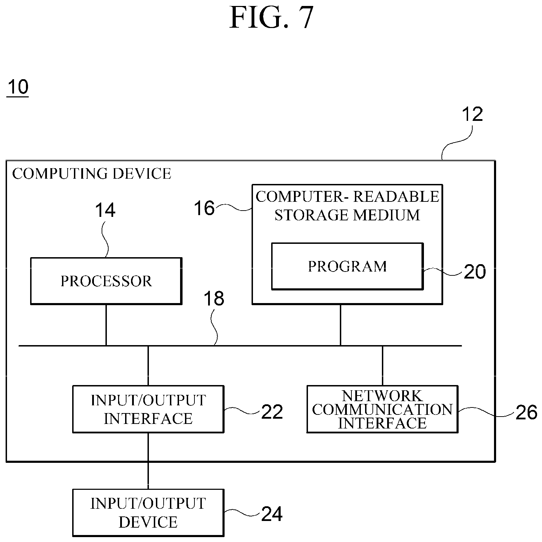

FIG. 7 is a block diagram for exemplarily illustrating a computing environment 10 including a computing device 12 according to one embodiment.

In the illustrated embodiment, respective components may have different functions and capabilities in addition to those described below, and additional components may be included in addition to those not described below.

The illustrated computing environment 10 includes a computing device 12. In one embodiment, the computing device 12 may be one or more components included in the apparatus 100 for successive cancellation list decoding of polar codes using power gating.

The computing device 12 includes at least one processor 14, a computer-readable storage medium 16, and a communication bus 18. The processor 14 may cause the computing device 12 to operate according to the above-described exemplary embodiments. For example, the processor 14 may execute one or more programs stored in the computer-readable storage medium 16. The one or more programs may include one or more computer-executable instructions, which may be configured to cause, when executed by the processor 14, the computing device 12 to perform operations according to the exemplary embodiments.

The computer-readable storage medium 16 is configured to store computer-executable instructions or program codes, program data, and/or other suitable forms of information. A program 20 stored in the computer-readable storage medium 16 includes a set of instructions executable by the processor 14. In one embodiment, the computer-readable storage medium 16 may be a memory (a volatile memory such as a random access memory, a non-volatile memory, or any suitable combination thereof), one or more magnetic disk storage devices, optical disc storage devices, flash memory devices, other types of storage media that are accessible by the computing device 12 and may store desired information, or any suitable combination thereof.

The communication bus 18 interconnects various other components of the computing device 12, including the processor 14 and the computer-readable storage medium 16.

The computing device 12 may also include one or more input/output interfaces 22 that provide an interface for one or more input/output devices 24, and one or more network communication interfaces 26. The input/output interface 22 and the network communication interface 26 are connected to the communication bus 18. The input/output device 24 may be connected to other components of the computing device 12 via the input/output interface 22. The exemplary input/output device 24 may include a pointing device (a mouse, a trackpad, or the like), a keyboard, a touch input device (a touch pad, a touch screen, or the like), a voice or sound input device, input devices such as various types of sensor devices and/or imaging devices, and/or output devices such as a display device, a printer, an interlocutor, and/or a network card. The exemplary input/output device 24 may be included inside the computing device 12 as one of components constituting the computing device 12, or may be connected to a computing device 12 as a separate device distinct from the computing device 12.

According to the disclosed embodiments, by using power gating in a successive cancellation list (SCL) decoding method, the SCL decoding method can have an effect of improving error correction performance while reducing the amount of calculation and the amount of power consumption, which are L times increased compared to the existing SC decoding method.

Although the representative embodiments of the present disclosure have been described in detail as above, those skilled in the art will understand that various modifications may be made thereto without departing from the scope of the present disclosure. Therefore, the scope of rights of the present disclosure should not be limited to the described embodiments, but should be defined not only by the claims set forth below but also by equivalents of the claims.

## Claims

1. An apparatus for successive cancellation list decoding of polar codes using power gating, the apparatus comprising:
a plurality of successive cancellation list decoders configured to receive a polar encoded codeword and decode the codeword using a successive cancellation list technique; and
a power gating circuit connected to a preset number of successive cancellation list decoders among the plurality of successive cancellation list decoders to control current supply.

2. The apparatus of claim 1, wherein the power gating circuit includes:
a signal generator configured to generate a power signal according to a preset condition; and
a current controller configured to control current supply to the preset number of successive cancellation list decoders by increasing or decreasing a gate voltage of a sleep transistor according to the generated power signal.

3. The apparatus of claim 2, wherein the signal generator is configured to generate a first power signal to block current supply to the preset number of successive cancellation list decoders in a decoding process when the plurality of successive cancellation list decoders receive the codeword.

4. The apparatus of claim 2, wherein the signal generator is configured to generate a second power signal to block current supply to the preset number of successive cancellation list decoders in a preset section during a decoding process when the plurality of successive cancellation list decoders receive the codeword.

5. The apparatus of claim 4, wherein the signal generator is configured to extract a Rate-1 node from the codeword when the plurality of successive cancellation list decoders receive the codeword and generate the second power signal to block current supply to the preset number of successive cancellation list decoders in a section corresponding to the Rate-1 node in the decoding process.

6. A method for successive cancellation list decoding of polar codes using power gating that is performed by a computing device comprising:
one or more processors; and
a memory storing one or more programs executed by the one or more processors, the method comprising:
generating a power signal according to a preset condition; and
controlling current supply to a plurality of successive cancellation list decoders by increasing or decreasing a gate voltage of a sleep transistor according to the generated power signal.

7. The method of claim 6, wherein the generating of the power signal includes generating a first power signal to block current supply to a preset number of successive cancellation list decoders among the plurality of successive cancellation list decoders in a decoding process when the plurality of successive cancellation list decoders receive a codeword.

8. The method of claim 6, wherein the generating of the power signal includes generating a second power signal to block current supply to a preset number of successive cancellation list decoders among the plurality of successive cancellation list decoders in a preset section during a decoding process when the plurality of successive cancellation list decoders receive the codeword.

9. The method of claim 8, wherein the generating of the power signal includes:
extracting a Rate-1 node from the codeword when the plurality of successive cancellation list decoders receive the codeword; and
generating the second power signal to block current supply to the preset number of successive cancellation list decoders in a section corresponding to the Rate-1 node in the decoding process.
